(19) **Europäisches Patentamt / European Patent Office / Office européen des brevets**

(11) **EP 3 683 913 B1**

(12) **EUROPEAN PATENT SPECIFICATION**

(45) Date of publication and mention
of the grant of the patent:
**22.02.2023 Bulletin 2023/08**

(21) Application number: **18881887.6**

(22) Date of filing: **11.10.2018**

(51) International Patent Classification (IPC):
*H02J 7/00* (2006.01)   *B60R 16/04* (2006.01)
*F02D 29/02* (2006.01)   *G01R 31/36* (2006.01)
*H01M 10/48* (2006.01)   *F02N 11/08* (2006.01)

(52) Cooperative Patent Classification (CPC):
**H02J 7/005; F02D 29/02; F02N 11/0825;
G01R 31/3647; G01R 31/389; G01R 31/52;
H01M 10/425; H01M 10/48; H02J 7/0029;**
B60R 16/033; F02N 2200/062; F02N 2200/063;
F02N 2200/064; H01M 2010/4278; H01M 2220/20;

(Cont.)

(86) International application number:
**PCT/JP2018/037933**

(87) International publication number:
**WO 2019/102735 (31.05.2019 Gazette 2019/22)**

(54) **RESTART DETERMINATION DEVICE, INTERNAL-SHORT DETERMINATION DEVICE, RESTART DETERMINATION METHOD, AND COMPUTER PROGRAM**

NEUSTARTBESTIMMUNGSVORRICHTUNG, INTERNE KURZSCHLUSSBESTIMMUNGSVORRICHTUNG, NEUSTARTBESTIMMUNGSVERFAHREN UND COMPUTERPROGRAMM

DISPOSITIF DE DÉTERMINATION DE REDÉMARRAGE, DISPOSITIF DE DÉTERMINATION DE COURT-CIRCUIT INTERNE, PROCÉDÉ DE DÉTERMINATION DE REDÉMARRAGE ET PROGRAMME INFORMATIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **22.11.2017 JP 2017225039**

(43) Date of publication of application:
**22.07.2020 Bulletin 2020/30**

(73) Proprietor: **GS Yuasa International Ltd.
Kyoto-shi, Kyoto 601-8520 (JP)**

(72) Inventors:
• **HARADA, Misaki
Kosai-shi, Shizuoka 431-0452 (JP)**
• **NAKANISHI, Yuki
Kosai-shi, Shizuoka 431-0452 (JP)**
• **MORISHIMA, Shoya
Kosai-shi, Aichi 431-0452 (JP)**
• **SUGIE, Kazuhiro
Kosai-shi, Shizuoka 431-0452 (JP)**

(74) Representative: **Isarpatent
Patent- und Rechtsanwälte Barth
Charles Hassa Peckmann & Partner mbB
Friedrichstrasse 31
80801 München (DE)**

(56) References cited:
JP-A- 2010 023 660   JP-A- 2010 066 161
JP-A- 2015 075 009   JP-A- 2016 211 405
JP-A- 2017 003 286   US-A1- 2007 013 347

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

(52) Cooperative Patent Classification (CPC): (Cont.)
     Y02E 60/10; Y02T 10/40

# EP 3 683 913 B1

**Description**

TECHNICAL FIELD

The present invention relates to a restart determination device that determines whether or not a restart of an engine is possible during an idling stop, an internal short-circuit determination device that determines whether or not an internal short-circuit has occurred in an energy storage device during an idling stop, a restart determination method, and a computer program for causing a computer to execute a restart determination process.

BACKGROUND ART

For example, a secondary battery (energy storage device) such as a lead-acid battery is mounted on a moving body such as a vehicle, and is used as a power supply source for a starter motor when starting an engine and a power supply source for various electric components such as lights.

When a vehicle is stopped, such as when waiting for a traffic light, for the purpose of suppressing energy consumption and noise, a control called idling stop for temporarily stopping an engine, restarting the engine when the stop condition of the vehicle is canceled, such as when a traffic light changes, and restarting traveling is performed.

If the battery short-circuits internally during an idling stop, the internal resistance increases despite the small amount of discharge, so the battery discharge voltage value after stopping the idling stop becomes low, and the engine may not be able to restart.

Therefore, it is necessary to detect the internal state (deterioration state) of the battery.

The deterioration state determination device of Patent Document 1 estimates an equivalent series resistance of an auxiliary battery based on a detected value of a voltage between terminals of the auxiliary battery and a detected value of a current flowing through the auxiliary battery during a period in which power is supplied from the auxiliary battery. The equivalent series resistance is corrected based on SOC of the auxiliary battery and a detected temperature value of the auxiliary battery. The deterioration state of the auxiliary battery is determined based on the corrected equivalent series resistance. Patent Document 2 describes a specific battery detection means that specifies single batteries believed to be in an excess discharge state during operation of the electric motor for starting the engine.

PRIOR ART DOCUMENT

PATENT DOCUMENT

    Patent Document 1: JP-A-2016-114584
    Patent Document 2: US 2007/0013347 A1

SUMMARY OF THE INVENTION

PROBLEMS TO BE SOLVED BY THE INVENTION

In the deterioration state determination device of Patent Document 1, the internal state of the battery is detected during traveling. The battery used is a battery for hybrid vehicles, which is used at around 50% SOC, and can detect the internal state in both cases of charging and discharging.

In the case of a lead-acid battery, it is used on the high SOC side, and the internal resistance value during charging and the internal resistance value during discharging do not have a linear relationship. Therefore, it is not possible to detect a short circuit by applying the internal state determination method of Patent Document 1 and accurately determine whether or not a restart of the engine is possible.

The present invention has an object to provide a restart determination device that can determine whether or not a restart is possible during an idling stop and can prevent restart failure due to inability to discharge, an internal short-circuit determination device that can determine the presence or absence of an internal short-circuit during the idling stop, a restart determination method, and a computer program.

MEANS FOR SOLVING THE PROBLEMS

The scope of the present invention is defined by the independent claims. A restart determination device according to the present invention includes a voltage value acquisition unit that acquires a first voltage value between terminals of an energy storage device during an idling stop for stopping idling of an engine, a current value acquisition unit that acquires a value of a current flowing through the energy storage device during the idling stop, a calculation unit that calculates an internal resistance value of the energy storage device during the idling stop, based on the first voltage value, the current value, and a no-load voltage value, and a determination unit that determines whether or not a restart of the engine is possible based on the internal resistance value and an operating voltage value of a starter motor of the engine.

ADVANTAGES OF THE INVENTION

According to the present invention, since the internal resistance value of the energy storage device during the idling stop is calculated based on the first voltage value, the current value, and the no-load voltage value, internal short-circuit of the energy storage device can be accurately detected during the idling stop. It is possible to accurately determine whether or not a restart of the engine is possible when idling stop is stopped, based on the degree of internal short-circuit corresponding to the internal resistance value and the operating voltage value of the starter motor.

BRIEF DESCRIPTION OF THE DRAWINGS

Fig. 1 is an explanatory view schematically showing an electric configuration of a vehicle according to a first embodiment.
Fig. 2 is a block diagram showing a configuration of a BMU.
Fig. 3 is a perspective view showing an external configuration of a battery.
Fig. 4 is a cross-sectional view taken along line IV-IV of Fig. 3.
Fig. 5 is a graph showing the relationship between the SOC and the internal resistance value of a battery having an internal short-circuit and a normal battery.
Fig. 6 is a graph showing the relationship between the SOC and the internal resistance value of a battery having an internal short-circuit and a normal battery.
Fig. 7 is an explanatory diagram showing a mechanism of a detection operation.
Fig. 8 is a cross-sectional view showing a pair of a positive electrode plate and a negative electrode plate, and a separator of a battery cell when no internal short-circuit occurs.
Fig. 9 is a cross-sectional view showing a pair of a positive electrode plate and a negative electrode plate, and a separator of a battery cell when a lower cell short-circuit occurs.
Fig. 10 is a cross-sectional view showing a pair of a positive electrode plate and a negative electrode plate, and a separator of a battery cell when a current collector passes through the separator.
Fig. 11 is a flowchart showing a processing procedure of a restart determination of a control unit.

MODE FOR CARRYING OUT THE INVENTION

[Overview of the present embodiment]

A restart determination device according to the present embodiment includes a voltage value acquisition unit that acquires a first voltage value between terminals of an energy storage device during an idling stop for stopping idling of an engine, a current value acquisition unit that acquires a value of a current flowing through the energy storage device during the idling stop, a calculation unit that calculates an internal resistance value of the energy storage device during the idling stop, based on the first voltage value, the current value, and a no-load voltage value, and a determination unit that determines whether or not a restart of the engine is possible based on the internal resistance value and an operating voltage value of a starter motor of the engine.

When an internal short-circuit occurs in the energy storage device during the idling stop, the internal resistance value increases. According to the above configuration, since the internal resistance value of the energy storage device during the idling stop is calculated based on the first voltage value, the current value, and the no-load voltage value, internal short-circuit of the energy storage device can be accurately detected during the idling stop. It is possible to accurately determine whether or not a restart of the engine is possible when idling stop is stopped, based on the degree of internal short-circuit corresponding to the internal resistance value and the operating voltage value of the starter motor.

Even when the energy storage device discharges on the high SOC side, the internal resistance value can be calculated accurately, and the internal short-circuit of a lead-acid battery or the like can be detected accurately.

The above-described restart determination device includes an estimation unit that estimates a second voltage value of the energy storage device when the idling stop is stopped and the engine is restarted, based on the no-load voltage value, the internal resistance value, the current value, and a cranking current value, and the determination unit makes a determination based on the second voltage value and the operating voltage value.

Since the second voltage value of the energy storage device when the engine is restarted is estimated, based on the no-load voltage value, the current value when the engine is restarted (the sum of the current value and the cranking current value), and the internal resistance value, the accuracy of the estimation is high. By comparing the operating voltage value with the second voltage value, it is possible to accurately determine whether or not a restart of the engine is possible.

In the above-described restart determination device, the calculation unit may calculate the internal resistance value by dividing a difference between the no-load voltage value and the first voltage value by the current value.

The difference between the no-load voltage value and the first voltage value corresponds to the amount of decrease in the voltage value due to the internal short-circuit, and by dividing this by the current value, the internal resistance value due to the internal short-circuit can be favorably calculated.

The above-described restart determination device may include a request unit that stops the idling stop and requests a restart when the determination unit determines that the restart is not possible.

Since the idling stop is stopped and the restart is requested before the discharge voltage value decreases and becomes lower than the operating voltage value, the restart failure due to inability to discharge is successfully prevented.

The above-described restart determination device may include a storage unit that stores a map representing the no-load voltage value for each temperature and each SOC of the energy storage device during the idling stop, and the calculation unit may refer to the map and acquire the no-load voltage value.

By compensating for the temperature and the SOC, the no-load voltage value becomes more accurate, and the accuracy of the determination is further improved.

The internal short-circuit determination device according to the present embodiment includes a voltage value acquisition unit that acquires a voltage value between terminals of the energy storage device during an idling stop for stopping idling of the engine, a current value acquisition unit that acquires a value of a current flowing through the energy storage device during the idling stop, a calculation unit that calculates an internal resistance value of the energy storage device during the idling stop based on the voltage value, the current value, and a no-load voltage value, and a determination unit that determines the presence or absence of an internal short-circuit in the energy storage device based on the internal resistance value.

As described above, when an internal short-circuit occurs in the energy storage device during the idling stop, since the internal resistance value increases, it is possible to determine the presence or absence of the internal short-circuit in the energy storage device, based on the internal resistance value. Since the internal state (deterioration) of the energy storage device can be detected, it is possible to determine whether or not a restart is possible and to take a measure such as charging or replacing the energy storage device.

The restart determination method according to the present embodiment includes, acquiring a voltage value between terminals of an energy storage device and a value of a current flowing through the energy storage device during an idling stop for stopping idling of an engine, calculating an internal resistance value of the energy storage device during the idling stop, based on the voltage value, the current value, and a no-load voltage value, and determining whether or not a restart of the engine is possible, based on the internal resistance value and an operating voltage value of a starter motor of the engine.

According to the above configuration, since the internal resistance value of the energy storage device during the idling stop is calculated based on the first voltage value, the current value, and the no-load voltage value, internal short-circuit of the energy storage device can be accurately detected during the idling stop. Therefore, it is possible to accurately determine whether or not a restart of the engine is possible when the idling stop is stopped, based on the degree of the internal short-circuit corresponding to the internal resistance value and the operating voltage value of the starter motor.

The computer program according to the present embodiment causes a computer to execute a process of, acquiring a voltage value between terminals of an energy storage device and a value of a current flowing through the energy storage device during an idling stop for stopping idling of an engine, calculating an internal resistance value of the energy storage device during the idling stop, based on the voltage value, the current value, and a no-load voltage value, and determining whether or not a restart of the engine is possible, based on the internal resistance value and an operating voltage value of a starter motor of the engine.

According to the above configuration, since the internal resistance value of the energy storage device during the idling stop is calculated based on the first voltage value, the current value, and the no-load voltage value, internal short-circuit of the energy storage device can be accurately detected during the idling stop. Therefore, it is possible to accurately determine whether or not a restart of the engine is possible when the idling stop is stopped, based on the degree of the internal short-circuit corresponding to the internal resistance value and the operating voltage value of the starter motor.

[First embodiment]

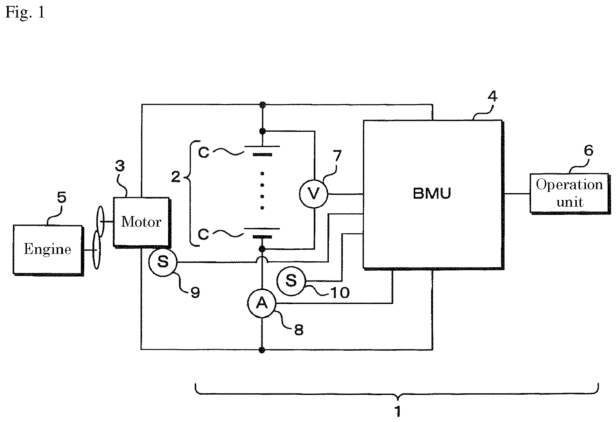

Fig. 1 is an explanatory diagram schematically showing an electric configuration of a vehicle according to the first embodiment.

The vehicle includes a vehicle control device 1, a motor (starter motor) 3, and an engine 5.

The vehicle control device 1 includes a lead-acid battery (hereinafter, referred to as a battery) 2, a BMU (Battery Management Unit) 4, an operation unit 6, a voltage sensor 7, a current sensor 8, a first temperature sensor 9, and a second temperature sensor 10.

The battery 2 has a plurality of cells C connected in series.

The voltage sensor 7 is connected in parallel to the battery 2 and outputs a detection result according to the overall voltage value of the battery 2. The current sensor 8 is connected in series to the battery 2 and outputs a detection result according to the value of a current (charge-discharge current) flowing through the battery 2. The first temperature sensor 9 is disposed near the motor 3 and outputs a detection result according to the temperature of the motor 3. The second temperature sensor 10 is disposed near the battery 2 and outputs a detection result according to the temperature of the battery 2.

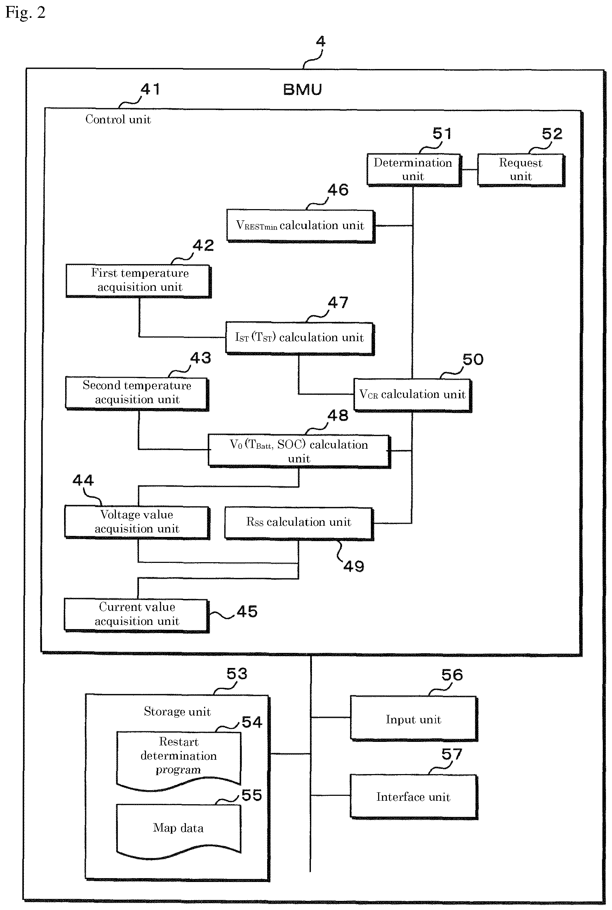

Fig. 2 is a block diagram showing a configuration of the BMU 4. The BMU 4 includes a control unit 41, a storage unit 53, an input unit 56, and an interface unit 57. These units are communicably connected to each other via a bus.

The input unit 56 receives input of detection results from the voltage sensor 7, the current sensor 8, the first temperature sensor 9, and the second temperature sensor 10. The interface unit 57 includes, for example, a LAN interface, a USB interface, and the like, and performs communication with another device such as the operation unit 6 by wire or wirelessly.

The storage unit 53 is composed of, for example, a hard disk drive (HDD) and stores various programs and data. The storage unit 53 stores, for example, a restart determination program 54 for executing a restart determination process described later. The restart determination program 54 is provided in a state stored in a computer-readable recording medium (not shown) such as a CD-ROM, a DVD-ROM, and a USB memory, and is stored in the storage unit 53 by being installed in the BMU 4. In addition, the storage unit 53 stores map data 55. The map data 55 is data representing a no-load voltage value $V_0$ for each temperature and each SOC of the battery 2 during the idling stop, is obtained by an experiment in advance, is input to the BMU 4 via the interface unit 57, and is stored in the storage unit 53.

The control unit 41 is configured by, for example, a CPU, a ROM, a RAM, and the like, and controls the operation of the BMU 4 by executing a computer program such as the restart determination program 54 read from the storage unit 53. For example, by reading and executing the restart determination program 54, the control unit 41 functions as a processing unit that executes a restart determination process described later.

Specifically, the control unit 41 includes a first temperature acquisition unit 42, a second temperature acquisition unit 43, a voltage value acquisition unit 44, a current value acquisition unit 45, a $V_{RESTmin}$ calculation unit 46, an $I_{ST}$ ($T_{ST}$) calculation unit 47, a $V_0$ ($T_{Batt}$, SOC) calculation unit 48, an Rss calculation unit 49, a $V_{CR}$ calculation unit 50, a determination unit 51, and a request unit 52. The functions of these units will be described later in the description of the restart determination process.

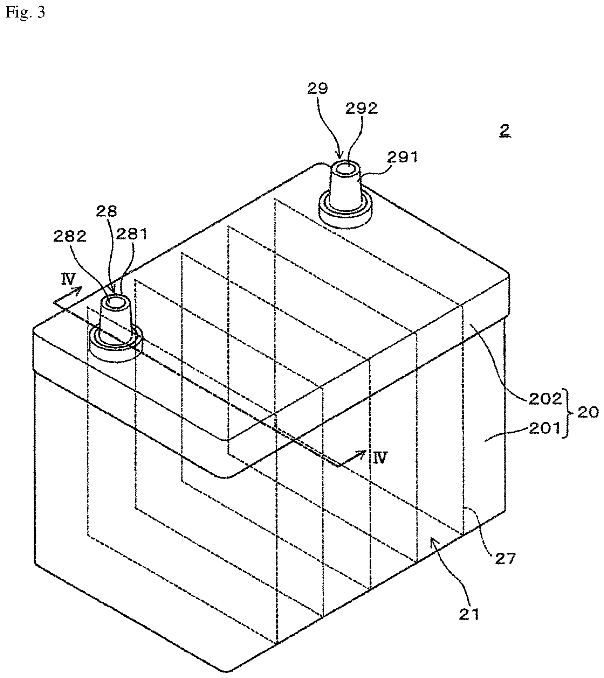

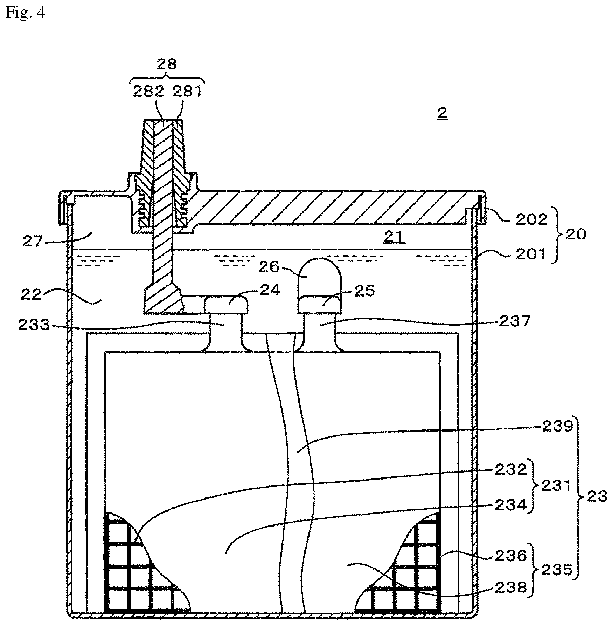

Fig. 3 is a perspective view showing an external configuration of the battery 2, and Fig. 4 is a cross-sectional view taken along line IV-IV of Fig. 3.

As shown in Figs. 3 and 4, the battery 2 includes a case 20, a positive electrode terminal 28, a negative electrode terminal 29, and a plurality of plate groups 23.

The case 20 has a case body 201 and a cover plate 202. The case body 201 is a rectangular parallelepiped container with an upper portion opened, and is formed of, for example, a synthetic resin. For example, the synthetic resin cover plate 202 closes an opening of the case body 201. The peripheral portion of the lower surface of the cover plate 202 and the peripheral portion of the opening of the case body 201 are joined by, for example, heat welding. The space in the case 20 is partitioned by a partition wall 27 into a plurality of cell chambers 21 arranged in the longitudinal direction of the case 20.

One plate group 23 is housed in each cell chamber 21 in the case 20. Each cell chamber 21 in the case 20 contains an electrolytic solution 22 containing diluted sulfuric acid, and the entire plate group 23 is immersed in the electrolytic solution 22. The electrolytic solution 22 is injected into the cell chamber 21 from an electrolyte solution filling port (not shown) provided in the cover plate 202.

The plate group 23 includes a plurality of positive electrode plates 231, a plurality of negative electrode plates 235, and a separator 239. The plurality of positive electrode plates 231 and the plurality of negative electrode plates 235 are arranged alternately.

The positive electrode plate 231 includes a current collector 232 and an active material layer 234 supported by the current collector 232. The current collector 232 is a conductive member having a bone portion arranged substantially in a lattice or mesh shape, and is formed of, for example, lead or a lead alloy. The current collector 232 has a tab 233 protruding upward near the upper end. The active material layer 234 contains lead dioxide. The active material layer 234 may further contain a known additive.

The negative electrode plate 235 includes a current collector 236 and an active material layer 238 supported by the current collector 236. The current collector 236 is a conductive member having a bone portion arranged substantially in a lattice or mesh shape, and is formed of, for example, lead or a lead alloy. The current collector 236 has a tab 237 protruding upward near the upper end. The active material layer 238 contains lead. The active material layer 238 may further contain a known additive.

The separator 239 is formed of, for example, an insulating material such as glass and a synthetic resin. The separator 239 is interposed between the adjacent positive electrode plate 231 and negative electrode plate 235. The separator 239 may be configured as an integral member, or may be separately provided between the positive electrode plate 231 and the negative electrode plate 235.

Tabs 233 of the plurality of positive electrode plates 231 are connected to a strap 24 formed of, for example, lead or a lead alloy. The plurality of positive electrode plates 231 are electrically connected in parallel via the strap 24. Similarly, tabs 237 of the plurality of negative electrode plates 235 are connected to a strap 25 formed of, for example, lead or a lead alloy. The plurality of negative electrode plates 235 are electrically connected in parallel via the strap 25.

In the battery 2, a strap 25 in one cell chamber 21 is connected to a strap 24 in a first cell chamber 21 adjacent to the one cell chamber 21 via a connection member (bus bar) 26 formed of, for example, lead or a lead alloy. Further, a strap 24 in the one cell chamber 21 is connected via a connection member 26 to a strap 25 in a second cell chamber 21 adjacent to the one cell chamber 21. That is, the plurality of plate groups 23 of the battery 2 are electrically connected in series via the straps 24 and 25 and the connection member 26. As shown in Fig. 4, the strap 24 housed in the cell chamber 21 located at one end in the direction in which the cells C are arranged is connected not to the connection member 26 but to a positive pole 282 described later. The strap 25 housed in the cell chamber 21 located at the other end in the direction in which the cells C are arranged is connected not to the connection member 26 but to a negative pole 292 (not shown).

The positive electrode terminal 28 is disposed at one end in a direction in which the cells C are arranged, and the negative electrode terminal 29 is disposed near the other end in the direction.

As shown in Fig. 4, the positive electrode terminal 28 includes a bushing 281 and the positive pole 282. The bushing 281 is a substantially cylindrical conductive member, and is formed of, for example, a lead alloy. The lower portion of the bushing 281 is integrated with the cover plate 202 by insert molding, and the upper portion of the bushing 281 protrudes upward from the upper surface of the cover plate 202. The positive pole 282 is a substantially columnar conductive member, and is formed of, for example, a lead alloy. The positive pole 282 is inserted into a hole of the bushing 281. The upper end of the positive pole 282 is located at substantially the same position as the upper end of the bushing 281 and is joined to the bushing 281 by, for example, welding. The lower end of the positive pole 282 protrudes below the lower end of the bushing 281 and further protrudes below the lower surface of the cover plate 202, and is connected to the strap 24 housed in the cell chamber 21 located at one end in the direction in which the cells C are arranged.

Similarly to the positive electrode terminal 28, the negative electrode terminal 29 includes a bushing 291 and a negative pole 292 (see Fig. 3), and has the same configuration as the positive electrode terminal 28.

When the battery 2 is discharged, a load (not shown) is connected to the bushing 281 of the positive electrode terminal 28 and the bushing 291 of the negative electrode terminal 29, and an electric power generated by a reaction on the positive electrode plate 231 (a reaction that generates lead sulfate from lead dioxide) and a reaction on the negative electrode plate 235 (a reaction that generates lead sulfate from lead (spongy lead)) of each plate group 23 is supplied to the load. Further, when the battery 2 is charged, a power supply (not shown) is connected to the bushing 281 of the positive electrode terminal 28 and the bushing 291 of the negative electrode terminal 29, and the power supplied from the power supply causes the reaction on the positive electrode plate 231 (a reaction that generates lead dioxide from lead sulfate) and the reaction on the negative electrode plate 235 (a reaction that generates lead (spongy lead) from lead sulfate) of each plate group 23 to occur, and the battery 2 is charged.

Hereinafter, the restart determination process according to the present embodiment will be described in detail.

The control unit 41 of the BMU 4 acquires a voltage value between the positive electrode terminal 28 and the negative electrode terminal 29 of the battery 2 and a value of a current flowing through the battery 2 during an idling stop for stopping idling of the engine 5, calculates an internal resistance value of the battery 2 during the idling stop based on the voltage value, the current value and the no-load voltage value, and determines whether or not a restart of the engine 5 is possible based on the internal resistance value and the operating voltage value at least required for restarting the engine 5 of the motor 3.

That is, the voltage value acquisition unit 44 acquires the voltage value (first voltage value) $V_{BattSS}$ between the positive electrode terminal 28 and the negative electrode terminal 29 of the battery 2 from the voltage sensor 7 during the idling stop.

The current value acquisition unit 45 acquires the current value $I_{EL}$ from the current sensor 8 during the idling stop. The current value $I_{EL}$ is a current value of a load such as the control unit 41 that operates during the idling stop.

The first temperature acquisition unit 42 acquires the temperature $T_{ST}$ of the motor 3 from the first temperature sensor 9.

The second temperature acquisition unit 43 acquires the temperature $T_{Batt}$ of the battery 2 from the second temperature sensor 10.

The $V_{RESTmin}$ calculation unit 46 calculates an operating voltage value $V_{RESTmin}$ required for restarting the engine 5 based on the configuration of the motor 3, the circuit, the starter relay, and the like.

The $I_{ST}$ ($T_{ST}$) calculation unit 47 performs temperature compensation on the cranking current value $I_{ST}$ based on the temperature $T_{ST}$ of the motor 3 acquired from the first temperature acquisition unit 42, and calculates $I_{ST}$ ($T_{ST}$).

The $V_0(T_{Batt}$, SOC) calculation unit 48 obtains the no-load voltage value $V_0(T_{Batt}$, SOC) with reference to the map data 55 stored in the storage unit 53.

Table 1 below shows an example of the map data 55.

[Table 1]

| | | SOC | | | | | | | | | | |
|---|---|---|---|---|---|---|---|---|---|---|---|---|
| | | 0% | 10% | 20% | 30% | 40% | 50% | 60% | 70% | 80% | 90% | 100% |
| Temperature | 10°C | 10.89 V | 11.46 V | 11.66 V | 11.80 V | 11.91 V | 12.01 V | 12.10 V | 12.18 V | 12.26 V | 12.32 V | 12.44 V |
| | 25°C | 11.20 V | 11.58 V | 11.75 V | 11.88 V | 11.99 V | 12.08 V | 12.17 V | 12.25 V | 12.33 V | 12.40 V | 12.53 V |
| | 40°C | 11.52 V | 11.70 V | 11.84 V | 11.96 V | 12.06 V | 12.15 V | 12.24 V | 12.33 V | 12.40 V | 12.48 V | 12.63 V |

When the numerical value of the temperature $T_{Batt}$ or SOC is between the numerical values of the temperature or SOC in the map data 55, the $V_0(T_{Batt}, SOC)$ calculation unit 48 calculates $V_0(T_{Batt}, SOC)$ by performing linear interpolation.

The Rss calculation unit 49 calculates the internal resistance value Rss by the following equation (1) using the no-load voltage value $V_0(T_{Batt}, SOC)$, the temperature $V_{BattSS}$, and the current value $I_{EL}$.

$$R_{SS} = (V_0(T_{Batt}, SOC) - V_{BattSS})/I_{EL} \,...(1)$$

The $V_{CR}$ calculation unit 50 calculates an estimated voltage value (second voltage value) $V_{CR}$ when stopping the idling stop and operating the motor 3 by the following equation (2) using the no-load voltage value $V_0(T_{Batt}, SOC)$, the internal resistance value Rss, the cranking current value $I_{ST}(T_{ST})$, and the current value $I_{EL}$.

$$V_{CR} = V_0(T_{Batt}, SOC) - R_{SS} \times (I_{ST}(T_{ST}) + I_{EL}) \,...(2)$$

The determination unit 51 compares the second voltage value $V_{CR}$ with the operating voltage value $V_{RESTmin}$ to determine whether a restart is possible. When $V_{CR} \geq V_{RESTmin}$, the determinatioon unit 51 determines that the restart is possible. When $V_{CR} < V_{RESTmin}$, the determination unit 51 determines that the restart is not possible.

If the determination unit 51 determines that the restart is not possible, the request unit 52 stops the idling stop and requests the restart of the engine 5.

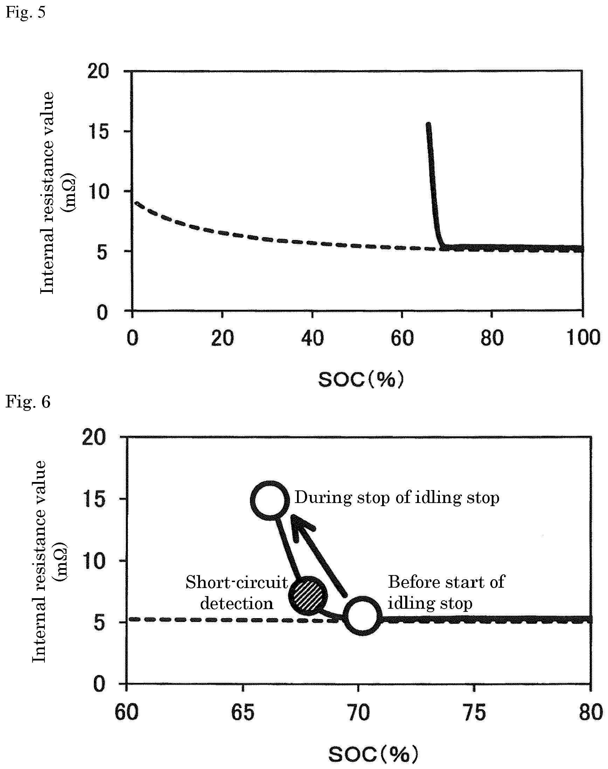

Fig. 5 is a graph showing the relationship between the SOC and the internal resistance value for a battery that has been internally short-circuited and a normal battery. The horizontal axis represents SOC (%), and the vertical axis represents internal resistance value (mS2). The battery short-circuited internally at 70% SOC. In the drawing, a battery with an internal short-circuit is shown by a solid line, and a normal battery is shown by a broken line.

From Fig. 5, it can be seen that the internal resistance value sharply increases due to the internal short-circuit despite the small amount of discharge.

Fig. 6 is a graph showing the relationship between the SOC and the internal resistance value for a battery that has been internally short-circuited and a normal battery. The horizontal axis represents SOC (%), and the vertical axis represents internal resistance value (mS2). In the drawing, a battery with an internal short-circuit is shown by a solid line, and a normal battery is shown by a broken line.

In Fig. 6, when the internal resistance value was 5 m$\Omega$ before the start of the idling stop, the internal resistance value increased due to an internal short-circuit during the idling stop, and increased to 15 m$\Omega$ after the stop of the idling stop.

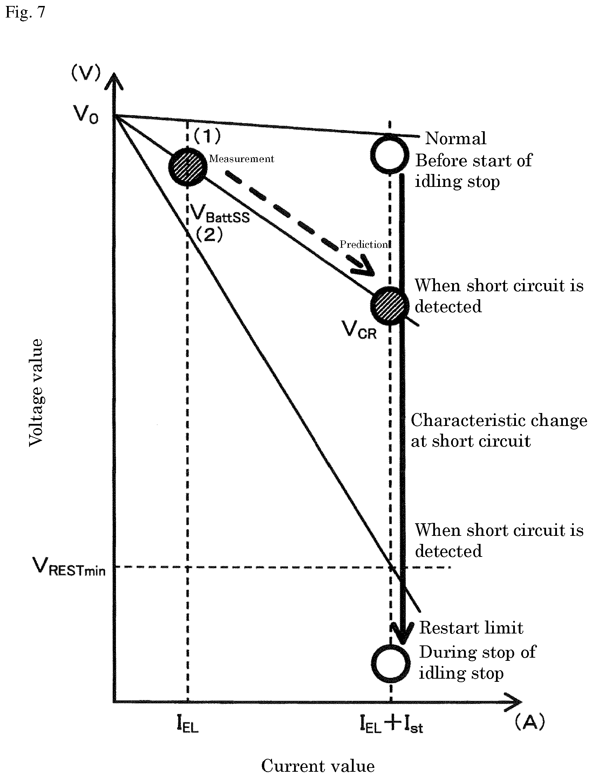

Fig. 7 is an explanatory diagram showing a mechanism of the detection operation. The horizontal axis represents the current value (A), and the vertical axis represents the voltage value (V).

The acquired voltage value at the time of measurement (1) during an idling stop in Fig. 7 is $V_{BattSS}$, and the acquired current value is $I_{EL}$. The internal resistance value Rss at this time is obtained by the above equation (1). In this internal resistance value Rss, the current value is made to correspond to the total value of $I_{EL}$ and $I_{ST}(T_{ST})$ from $I_{EL}$, and the second voltage value $V_{CR}$ when stopping the idling stop and operating the motor 3 is estimated.

In the case of a straight line (2), the internal resistance value Rss is larger than the internal resistance value Rss of (1), and the second voltage value $V_{CR}$ is smaller than the second voltage value $V_{CR}$ of (1) and is equal to the operating voltage value $V_{RESTmin}$ at least required for restarting the engine 5. If the second voltage value $V_{CR}$ is smaller than the operating voltage value $V_{RESTmin}$, the engine 5 cannot be restarted. In this case, the determination unit 51 determines that restart is not possible, and the request unit 52 stops idling stop and requests restart.

Thereby, when the restart is requested after the idling stop is continued, it is prevented that the discharge cannot be performed and the restart fails.

That is, the second voltage value $V_{CR}$ obtained from the straight line (2) is a lower limit voltage value for determining whether or not the restart is possible.

Hereinafter, the types of internal short-circuits will be described.

(1) Extension of current collector 232 of positive electrode plate 231 and contact with tab 237 of negative electrode plate 235

In this case, the positive electrode current collector 232 shown in Fig. 4 extends upward and comes into contact with the negative electrode tab 237.

(2) Extension of current collector 232 of positive electrode plate 231 and contact with strap 25 of negative electrode plate 235

In this case, the positive electrode current collector 232 shown in Fig. 4 extends upward and comes into contact with the negative electrode strap 25.

(3) Deposition of dropped active material

In this case, the active material drops off from the active material layer 234 of the positive electrode plate 231, soars by the gas, and deposits on the tab 237 or the like of the negative electrode plate 235.

(4) Cell bottom short-circuit

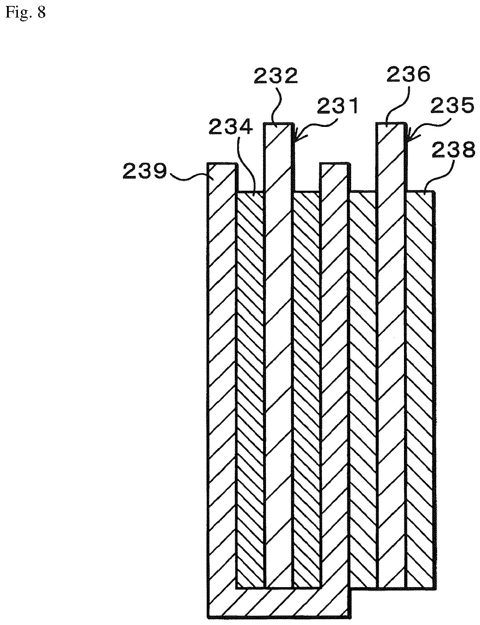

Fig. 8 is a cross-sectional view showing a pair of the positive electrode plate 231 and the negative electrode plate 235 and the separator 239 of the cell of the battery 2 when no internal short-circuit occurs.
Active material layers 234 and 238 are provided on both surfaces of the current collectors 232 and 236, respectively. The separator 239 is interposed between the opposing active material layers 234 and 238.

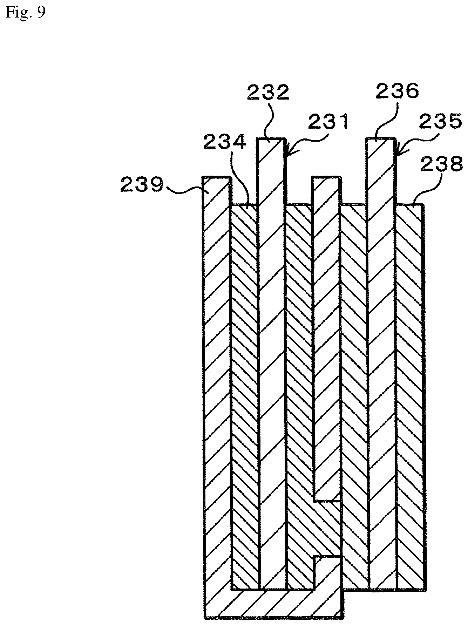

Fig. 9 is a cross-sectional view showing a pair of the positive electrode plate 231 and the negative electrode plate 235 and the separator 239 of the cell of the battery 2 when a cell bottom short-circuit occurs.
As shown in Fig. 9, the separator 239 is deteriorated to form a hole, and the active material layer 234 of the positive electrode plate 231 projects to the active material layer 238 of the negative electrode plate 235, and conducts.

(5) Penetration of current collector 232 of positive electrode plate 231 through separator 239

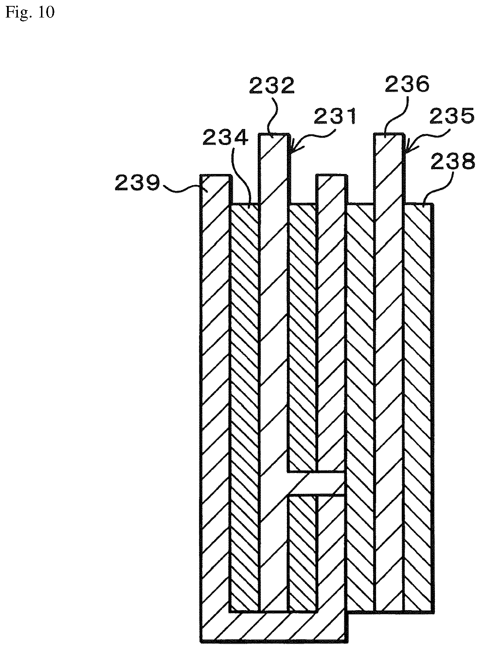

Fig. 10 is a cross-sectional view showing a pair of the positive electrode plate 231 and the negative electrode plate 235 and the separator 239 of the cell of the battery 2 when the current collector 232 penetrates through the separator 239.
The current collector 232 bends and penetrates through the separator 239.

(6) Penetration of current collector 236 of negative electrode plate 235 through separator 239

Contrary to (5), the current collector 236 bends and penetrates through the separator 239.

(7) Deterioration of separator 239

Lead sulfate permeates the separator 239 from the active material layer 238 of the negative electrode plate 235, and lead sulfate accumulates inside the separator 239 and enters the active material layer 234 of the positive electrode plate 231 to cause a short circuit.

(8) Dendrite short-circuit

Needle-like crystals (dendrites) permeate the separator 239 from the active material layer 238 of the negative electrode plate 235 and enter the active material layer 234 of the positive electrode plate 231 to cause a short circuit.

(9) Breakage of connection between cells

A gap is generated due to the deterioration of the connection member 26, and the active material layer 234 and the active material layer 238 are short-circuited.

(10) Foreign matter contamination

A short circuit occurs when a metal piece is mixed to electrically connect the positive electrode and the negative electrode, or when the metal dissolves and precipitates on the electrode plate or adheres to the separator 239 and breaks through.
Hereinafter, the restart determination process will be described as a process of the control unit 41.

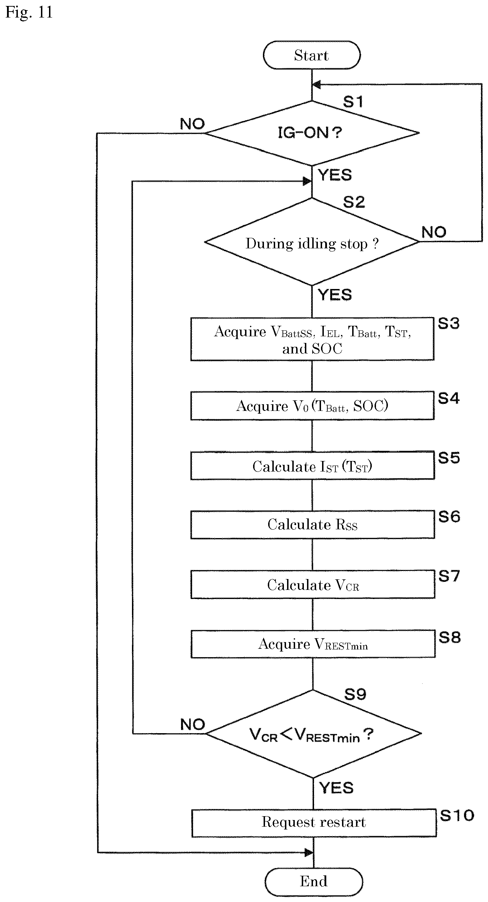

Fig. 11 is a flowchart illustrating a processing procedure of the restart determination of the control unit 41.
The determination unit 51 of the control unit 41 determines whether or not the state is an IG-ON (ignition-ON) state (S1).

11

The determination unit 51, when having determined that the state is not the IG-ON state (S1: NO), ends the restart determination process.

The determination unit 51, when having determined that the state is the IG-ON state (S1: YES), determines whether or not the vehicle is during an idling stop (S2).

The determination unit 51, when having determined that the vehicle is not during the idling stop (S2: NO), returns the process to S1.

The determination unit 51, when having determined that the vehicle is during the idling stop (S2: YES), acquires the first voltage value $V_{BattSS}$ by the voltage value acquisition unit 44, acquires the current value $I_{EL}$ by the current value acquisition unit 45, acquires the temperature $T_{Batt}$ by the second temperature acquisition unit 43, and acquires the temperature $T_{ST}$ by the first temperature acquisition unit 42. Then, the SOC is calculated based on the charge-discharge history stored in the storage unit 53 (S3).

The determination unit 51 acquires the no-load voltage value $V_0(T_{Batt}, SOC)$ by referring to the map data 55 based on the temperature $T_{Batt}$ and SOC acquired by the $V_0(T_{Batt}, SOC)$ calculation unit 48 (S4).

The determination unit 51 calculates the cranking current value $I_{ST}(T_{ST})$ by the $I_{ST}(T_{ST})$ calculation unit 47 (S5).

The determination unit 51 calculates the internal resistance value Rss using the equation (1) by the Rss calculation unit 49 (S6).

The determination unit 51 calculates the second voltage value $V_{CR}$ using the equation (2) by the $V_{CR}$ calculation unit 50 (S7).

The determination unit 51 calculates the operating voltage value $V_{RESTmin}$ by the $V_{RESTmin}$ calculation unit 46 (S8).

The determination unit 51 determines whether or not the second voltage value $V_{CR}$ is smaller than the operating voltage value $V_{RESTmin}$ (S9).

The determination unit 51, when having determined that the second voltage value $V_{CR}$ is not smaller than the operating voltage value $V_{RESTmin}$ (S9: NO), returns the process to S2.

When the determination unit 51 determines that the second voltage value $V_{CR}$ is smaller than the operating voltage value $V_{RESTmin}$ (S9: YES), the request unit 52 stops idling stop and requests a restart of the engine 5 (S 10).

As the temperature $T_{Batt}$, the temperature of the positive electrode terminal 28 or the negative electrode terminal 29 may be used. Alternatively, the liquid temperature estimated from the ambient temperature may be used. It may be calculated by the following equation (3).

$$T_{Batt} = \Delta T + \text{previous temperature of battery 2} \ldots (3)$$

where $\Delta T$ = (previous temperature of battery 2 - current ambient temperature)/(thermal resistance)

As the temperature $T_{ST}$, the water temperature of the engine 5 may be used.

The operating voltage value $V_{RESTmin}$ or the second voltage value $V_{CR}$ is preferably provided with a margin in consideration of the amount of electric power for restart. Thereby, failure of restart can be further prevented.

[First modification]

Instead of the second voltage value $V_{CR}$ of the battery 2, the second voltage value $V_{CR}(2)$ of the motor 3 when the engine 5 is restarted is used. The second voltage value $V_{CR}(2)$ of the motor 3 is calculated by the following equation (4).

$$V_{CR}(2) = V_0(T_{Batt}, SOC) - (R_{SS} + R_{WH} + R_{ST} + R_{CON}) \times (I_{ST}(T_{ST}) + I_{EL}) \ldots (4)$$

where $R_{WH}$: Resistance value of wire

$R_{ST}$: Resistance value of Motor 3
$R_{CON}$: Contact resistance value

According to the first modification, the second voltage value $V_{CR}(2)$ of the motor 3 is estimated, and whether the restart is possible or not is compared with the lowest operating voltage value $V_{RESTmin}$ of the motor 3, so that the determination accuracy is further improved.

[Second modification]

The second voltage value $V_{CR}(3)$ of the battery 2 is calculated in consideration of the increase amount of the short-circuit current value due to the external short-circuit of the battery 2. The second voltage value $V_{CR}(3)$ is calculated by the following equation (5).

$$V_{CR}(3) = V_0(T_{Batt}, SOC) - R_{SS} \times (I_{ST}(T_{ST}) + I_{EL} + I_{OSC}) \; ...(5)$$

where Iosc: current value of external short-circuit

[Third modification]

The second voltage value $V_{CR}(4)$ of the motor 3 in consideration of the increase amount of the short-circuit current value and the decrease amount of the resistance value due to the external short-circuit of the battery 2 is used. The second voltage value $V_{CR}(4)$ is calculated by the following equation (6).

$$V_{CR}(4) = V_0(T_{Batt}, SOC) - (R_{SS} + R_{WH} + R_{ST} + R_{CON} - R_{OSC}) \times (I_{ST}(T_{ST}) + I_{EL} +$$

$$I_{OSC}) \; ...(6)$$

where Rose: decrease amount in resistance value

[Fourth modification]

The control unit 41 functions as a processing unit that executes a process of determining the presence or absence of an internal short-circuit.
The control unit 41 determines the presence or absence of an internal short-circuit based on the internal resistance value Rss calculated by the Rss calculation unit 49. If the internal resistance value Rss is equal to or greater than the threshold, it is determined that an internal short-circuit has occurred during an idling stop.
Since the internal state (deterioration) of the battery 2 can be detected, it can be determined whether or not a restart of the engine 5 is possible. In addition, the occurrence of an internal short-circuit is notified in the operation unit 6, and measures such as charging or replacing the battery 2 can be taken.

[Verification result]

The following evaluation test was performed to verify the restart determination process of the present embodiment.
The vehicle was assumed to be a gasoline engine vehicle (1.5 L), and "S-95 (12V-60Ah) was used as the battery 2.
In the case where an internal short-circuit of the above-described classifications (1) to (10) was made to occur in the battery 2, the second voltage value $V_{CR}$ was calculated using the above equation (2), the voltage value was measured, and the error was obtained. The results are shown in Table 2 below. The operating voltage value $V_{RESTmin}$ is 3.5 V and $I_{ST}(T_{ST})$ is 250 A.

[Table 2]

| Classification | VCR | Measured voltage | Error | Start limit | Detection determination |
|---|---|---|---|---|---|
| (1) | 4.11 V | 4.99 V | 0.88 V | > 3.5 V | ○ |
| | 4.52 V | 4.06 V | 0.46 V | > 3.5 V | ○ |
| | 4.59 V | 5.00 V | 0.41 V | > 3.5 V | ○ |
| (2) | 5.52 V | 5.10 V | 0.42 V | > 3.5 V | ○ |
| | 5.07 V | 5.56 V | 0.49 V | > 3.5 V | ○ |
| | 5.86 V | 5.40 V | 0.46 V | > 3.5 V | ○ |

(continued)

| Classification | VCR | Measured voltage | Error | Start limit | Detection determination |
|---|---|---|---|---|---|
| (3) | 5.87 V | 5.92 V | 0.05 V | > 3.5 V | ○ |
| (3) | 5.25 V | 5.63 V | 0.38 V | > 3.5 V | ○ |
| (3) | 5.41 V | 5.24 V | 0.17 V | > 3.5 V | ○ |
| (4) | 5.11 V | 5.91 V | 0.80 V | > 3.5 V | ○ |
| (4) | 5.03 V | 5.73 V | 0.70 V | > 3.5 V | ○ |
| (4) | 5.48 V | 5.60 V | 0.12 V | > 3.5 V | ○ |
| (5) | 4.26 V | 4.63 V | 0.37 V | > 3.5 V | ○ |
| (5) | 5.11 V | 5.22 V | 0.11 V | > 3.5 V | ○ |
| (5) | 5.03 V | 5.81 V | 0.78 V | > 3.5 V | ○ |
| (6) | 5.88 V | 5.63 V | 0.25 V | > 3.5 V | ○ |
| (6) | 5.94 V | 5.66 V | 0.28 V | > 3.5 V | ○ |
| (6) | 5.04 V | 5.54 V | 0.50 V | > 3.5 V | ○ |
| (7) | 4.65 V | 4.10 V | 0.55 V | > 3.5 V | ○ |
| (7) | 5.14 V | 5.12 V | 0.02 V | > 3.5 V | ○ |
| (7) | 5.13 V | 5.24 V | 0.11 V | > 3.5 V | ○ |
| (8) | 5.28 V | 5.65 V | 0.37 V | > 3.5 V | ○ |
| (8) | 5.32 V | 5.55 V | 0.23 V | > 3.5 V | ○ |
| (8) | 5.50 V | 5.91V | 0.41 V | > 3.5 V | ○ |
| (9) | 4.15 V | 4.92 V | 0.77 V | > 3.5 V | ○ |
| (9) | 5.64 V | 5.32 V | 0.32 V | > 3.5 V | ○ |
| (9) | 5.16 V | 5.38 V | 0.22 V | > 3.5 V | ○ |
| (10) | 4.88 V | 4.52 V | 0.36 V | > 3.5 V | ○ |
| (10) | 4.90 V | 4.51 V | 0.39 V | > 3.5 V | ○ |
| (10) | 4.57 V | 4.91V | 0.34 V | > 3.5 V | ○ |
| Standard deviation | | | 0.23 V | | |

From Table 2, it was confirmed that no matter which internal short-circuit occurred, the occurrence of the internal short-circuit was able to be detected and it was able to be determined whether a restart was possible. The standard deviation of the error between the second voltage value $V_{CR}$ and the measured voltage value is 0.23 V, and the calculation accuracy of the second voltage value $V_{CR}$ is good.

As described above, in the present embodiment, the internal short-circuit of the battery 2 can be accurately detected by calculating the internal resistance value Rss during an idling stop. Based on the degree of internal short-circuit corresponding to the internal resistance value Rss and the operating voltage value $V_{RESTmin}$ of the motor 3, it is possible to accurately determine whether or not a restart of the engine 5 is possible when the idling stop is stopped. If it is determined that the restart of the engine 5 is impossible, it is possible to prevent the restart of the engine 5 from failing due to discharge failure by stopping the idling stop and requesting the restart of the engine 5.

When the second voltage value $V_{CR}$ of the battery 2 when restarting the engine 5 is estimated based on the no-load voltage value $V_0(T_{Batt}, SOC)$, the current value when restarting the engine 5 (the sum of the current value $I_{EL}$ and the cranking current value $I_{ST}(T_{ST})$), and the internal resistance value Rss, the estimation accuracy is high. Then, by comparing the operating voltage value $V_{RESTmin}$ with the second voltage value $V_{CR}$, it is possible to accurately determine whether a restart of the engine 5 is possible.

The present invention is not limited to the contents of the embodiments described above, and various modifications can be made within the scope of the claims. That is, embodiments obtained by combining technical means appropriately changed within the scope of the claims are also included in the technical scope of the present invention.

The present invention is not limited to the case where the present invention is applied to an in-vehicle secondary battery. The method is not limited to the case of determining whether or not the restart of the engine 5 is possible after detecting the internal short-circuit.

In the above embodiment, the case where the battery 2 is a lead-acid battery is described. However, the present invention is not limited to this, and a lithium ion battery or the like may be used.

In the above-described embodiment, the case where the control unit 41 of the BMU 4 is the restart determination device of the present invention and the internal short-circuit determination device is described. However, the present invention is not limited to this, and the ECU (Electronic Control Unit) may function as a restart determination device and an internal short-circuit determination device, or a control unit provided in the battery 2 may function as these devices. Further, the one provided in a server or the like external to the moving body may detect an internal short-circuit of the secondary battery provided in the moving body, and remotely manage the restart of the engine 5.

DESCRIPTION OF REFERENCE SIGNS

1: In-vehicle control device
2: Battery (energy storage device)
3: Motor
4: BMU
41: Control unit
44: Voltage value acquisition unit
45: Current value acquisition unit
49: Rss calculation unit
5: Engine
50: $V_{CR}$ calculation unit
51: Determination unit
52: Request unit
53: Storage unit
54: Restart determination program
6: Operation unit
7: Voltage sensor
8: Current sensor
9: First temperature sensor
10: Second temperature sensor

**Claims**

1. A restart determination device, comprising:

   a voltage value acquisition unit (44) configured to acquire a first voltage value ($V_{BattSS}$) between terminals (28, 29) of an energy storage device (2) during an idling stop for stopping idling of an engine (5);
   a current value acquisition unit (45) configured to acquire a value ($I_{EL}$) of a current flowing through the energy storage device (2) during the idling stop;
   a calculation unit (49) configured to calculate an internal resistance value ($R_{SS}$) of the energy storage device (2) during the idling stop, based on the first voltage value ($V_{BattSS}$), the current value ($I_{EL}$), and a no-load voltage value ($V_0$);
   an estimation unit configured to estimate a second voltage value ($V_{CR}$) of the energy storage device (2) when stopping the idling stop and restarting the engine (5), based on the no-load voltage value ($V_0$), the internal resistance value ($R_{SS}$), the current value ($I_{EL}$), and a cranking current value ($I_{ST}$); and
   a determination unit (51) configured to determine whether or not a restart of the engine (5) is possible, based on the second voltage value, $V_{CR}$, and an operating voltage value, $V_{RESTmin}$, of a starter motor (3) of the engine (5),
   wherein the determination unit (51) is configured to compare the second voltage value ($V_{CR}$) with the operating voltage value ($V_{RESTmin}$) to determine whether a restart is possible,
   wherein the determination unit (51) is configured to determine that the restart is possible when $V_{CR} \geq V_{RESTmin}$,

and the determination unit (51) is configured to determine that the restart is not possible when $V_{CR} < V_{RESTmin}$.

2. The restart determination device according to claim 1, wherein the calculation unit (49) is configured to calculate the internal resistance value ($R_{SS}$) by dividing a difference between the no-load voltage value ($V_0$) and the first voltage value ($V_{BattSS}$) by the current value ($I_{EL}$).

3. The restart determination device according to claim 1 or 2, further comprising a request unit (52) configured to stop the idling stop and request a restart when the determination unit (51) determines that VCR < VRESTmin, wherein the operating voltage value VRESTmin or the second voltage value VCR is provided with a margin in consideration of the amount of electric power for restart.

4. The restart determination device according to any one of claims 1 to 3, further comprising a storage unit (53) configured to store a map representing the no-load voltage value ($V_0$) for each temperature and each SOC of the energy storage device (2) during the idling stop,
wherein the calculation unit (49) is configured to acquire the no-load voltage value ($V_0$) with reference to the map.

5. An internal short-circuit determination device, comprising the restart determination device according to claim 1, wherein the determination unit (51) is further configured to determine presence or absence of an internal short-circuit in the energy storage device (2) based on the internal resistance value ($R_{SS}$).

6. A restart determination method, comprising:

acquiring a voltage value ($V_{BattSS}$) between terminals (28, 29) of an energy storage device (2) and a value ($I_{EL}$) of a current flowing through the energy storage device (2) during an idling stop for stopping idling of an engine (5);
calculating an internal resistance value ($R_{SS}$) of the energy storage device (2) during the idling stop, based on the voltage value ($V_{BattSS}$), the current value ($I_{EL}$), and a no-load voltage value ($V_0$);
estimating a second voltage value, $V_{CR}$, of the energy storage device (2) when stopping the idling stop and restarting the engine (5), based on the no-load voltage value ($V_0$), the internal resistance value ($R_{SS}$), the current value ($I_{EL}$), and a cranking current value ($I_{ST}$); and
determining whether or not a restart of the engine (5) is possible, based on the second voltage value ($V_{CR}$) and an operating voltage value, $V_{RESTmin}$, of a starter motor (3) of the engine (5),
wherein the second voltage value ($V_{CR}$) is compared with the operating voltage value ($V_{RESTmin}$) to determine whether a restart is possible,
wherein it is determined that the restart is possible when $V_{CR} \geq V_{RESTmin}$, and it is determined that the restart is not possible when $V_{CR} < V_{RESTmin}$.

7. A computer program for causing a computer to execute a process of:

acquiring a voltage value ($V_{BattSS}$) between terminals (28, 29) of an energy storage device (2) and a value ($I_{EL}$) of a current flowing through the energy storage device (2) during an idling stop for stopping idling of an engine (5);
calculating an internal resistance value ($R_{SS}$) of the energy storage device (2) during the idling stop, based on the voltage value ($V_{BattSS}$), the current value ($I_{EL}$), and a no-load voltage value ($V_0$);
estimating a second voltage value, $V_{CR}$, of the energy storage device (2) when stopping the idling stop and restarting the engine (5), based on the no-load voltage value ($V_0$), the internal resistance value ($R_{SS}$), the current value ($I_{EL}$), and a cranking current value ($I_{ST}$); and
determining whether or not a restart of the engine (5) is possible, based on the second voltage value ($V_{CR}$) and an operating voltage value, $V_{RESTmin}$, of a starter motor (3) of the engine (5),
wherein the second voltage value ($V_{CR}$) is compared with the operating voltage value ($V_{RESTmin}$) to determine whether a restart is possible,
wherein it is determined that the restart is possible when $V_{CR} \geq V_{RESTmin}$, and it is determined that the restart is not possible when $V_{CR} < V_{RESTmin}$.

**Patentansprüche**

1. Neustartbestimmungsvorrichtung, umfassend:

eine Spannungswert-Erfassungseinheit (44), die eingerichtet ist, um einen ersten Spannungswert ($V_{BattSS}$)

zwischen Anschlüssen (28, 29) einer Energiespeichervorrichtung (2) während eines Leerlaufstopps zum Stoppen des Leerlaufs eines Motors (5) zu erfassen;

eine Stromwert-Erfassungseinheit (45), die eingerichtet ist, um einen Wert ($I_{EL}$) eines Stroms zu erfassen, der durch die Energiespeichervorrichtung (2) während des Leerlaufstopps fließt;

eine Berechnungseinheit (49), die eingerichtet ist, um einen Innenwiderstandswert ($R_{ss}$) der Energiespeichervorrichtung (2) während des Leerlaufstopps zu berechnen, basierend auf dem ersten Spannungswert ($V_{BattSS}$), dem Stromwert ($I_{EL}$) und einem Leerlaufspannungswert ($V_0$);

eine Schätzeinheit, die eingerichtet ist, um einen zweiten Spannungswert ($V_{CR}$) der Energiespeichervorrichtung (2) zu schätzen, wenn der Leerlaufstopp gestoppt und der Motor (5) neugestartet wird, basierend auf dem Leerlaufspannungswert ($V_0$), dem Innenwiderstandswert ($R_{ss}$), dem Stromwert ($I_{EL}$) und einem Anlassstromwert ($I_{ST}$); und

eine Bestimmungseinheit (51), die eingerichtet ist, um zu bestimmen, ob ein Neustart des Motors (5) möglich ist oder nicht, basierend auf dem zweiten Spannungswert ($V_{CR}$) und einem Betriebsspannungswert ($V_{RESTmin}$) eines Anlassermotors (3) des Motors (5),

wobei die Bestimmungseinheit (51) eingerichtet ist, um den zweiten Spannungswert ($V_{CR}$) mit dem Betriebsspannungswert ($V_{RESTmin}$) zu vergleichen, um zu bestimmen, ob ein Neustart möglich ist,

wobei die Bestimmungseinheit (51) eingerichtet ist, um zu bestimmen, dass der Neustart möglich ist, wenn $V_{CR} \geq V_{RESTmin}$, und die Bestimmungseinheit (51) eingerichtet ist, zu bestimmen, dass der Neustart nicht möglich ist, wenn $V_{CR} < V_{RESTmin}$.

2.  Neustartbestimmungsvorrichtung nach Anspruch 1, wobei die Berechnungseinheit (49) eingerichtet ist, um den Innenwiderstandswert ($R_{ss}$) zu berechnen, indem sie eine Differenz zwischen dem Leerlaufspannungswert ($V_0$) und dem ersten Spannungswert ($V_{BattSS}$) durch den Stromwert ($I_{EL}$) teilt.

3.  Neustartbestimmungsvorrichtung nach Anspruch 1 oder 2, ferner umfassend eine Anforderungseinheit (52), die eingerichtet ist, um den Leerlaufstopp zu stoppen und einen Neustart anzufordern, wenn die Bestimmungseinheit (51) bestimmt, dass $V_{CR} < V_{RESTmin}$ ist, wobei der Betriebsspannungswert $V_{RESTmin}$ oder der zweite Spannungswert $V_{CR}$ mit einem Spielraum unter Berücksichtigung der Menge an elektrischer Energie für den Neustart versehen ist.

4.  Neustartbestimmungsvorrichtung nach einem der Ansprüche 1 bis 3, ferner umfassend eine Speichereinheit (53), die eingerichtet ist, um eine Karte zu speichern, welche den Leerlaufspannungswert ($V_0$) für jede Temperatur und jeden SOC der Energiespeichervorrichtung (2) während des Leerlaufstopps darstellt, wobei die Berechnungseinheit (49) eingerichtet ist, um den Leerlaufspannungswert ($V_0$) unter Bezugnahme auf die Karte zu erfassen.

5.  Bestimmungsvorrichtung für einen internen Kurzschluss, die die Neustartbestimmungsvorrichtung nach Anspruch 1 umfasst, wobei die Bestimmungseinheit (51) ferner eingerichtet ist, um ein Vorhandensein oder Nichtvorhandensein eines internen Kurzschlusses in der Energiespeichervorrichtung (2) basierend auf dem Innenwiderstandswert ($R_{ss}$) zu bestimmen.

6.  Neustartbestimmungsverfahren, umfassend:

Erfassen eines Spannungswerts ($V_{BattSS}$) zwischen Anschlüssen (28, 29) einer Energiespeichervorrichtung (2) und eines Werts ($I_{EL}$) eines Stroms, der durch die Energiespeichervorrichtung (2) während eines Leerlaufstopps zum Stoppen des Leerlaufs eines Motors (5) fließt;

Berechnen eines Innenwiderstandswerts ($R_{ss}$) der Energiespeichervorrichtung (2) während des Leerlaufstopps basierend auf dem Spannungswert ($V_{BattSS}$), dem Stromwert ($I_{EL}$) und einem Leerlaufspannungswert ($V_0$);

Schätzen eines zweiten Spannungswerts ($V_{CR}$) der Energiespeichervorrichtung (2), wenn der Leerlaufstopp gestoppt und der Motor (5) neugestartet wird, basierend auf dem Leerlaufspannungswert ($V_0$), dem Innenwiderstandswert ($R_{ss}$), dem Stromwert ($I_{EL}$) und einem Anlassstromwert ($I_{ST}$); und

Bestimmen, ob ein Neustart des Motors (5) möglich ist oder nicht, basierend auf dem zweiten Spannungswert ($V_{CR}$) und einem Betriebsspannungswert ($V_{RESTmin}$) eines Anlassermotors (3) des Motors (5),

wobei der zweite Spannungswert ($V_{CR}$) mit dem Betriebsspannungswert ($V_{RESTmin}$) verglichen wird, um zu bestimmen, ob ein Neustart möglich ist,

wobei bestimmt wird, dass der Neustart möglich ist, wenn $V_{CR} \geq V_{RESTmin}$ ist, und bestimmt wird, dass der Neustart nicht möglich ist, wenn $V_{CR} < V_{RESTmin}$ ist.

7.  Computerprogramm zum Veranlassen eines Computers, einen Prozess auszuführen, der umfasst:

Erfassen eines Spannungswerts ($V_{BattSS}$) zwischen Anschlüssen (28, 29) einer Energiespeichervorrichtung (2) und eines Werts ($I_{EL}$) eines Stroms, der durch die Energiespeichervorrichtung (2) während eines Leerlaufstopps zum Stoppen des Leerlaufs eines Motors (5) fließt;

Berechnen eines Innenwiderstandswerts ($R_{ss}$) der Energiespeichervorrichtung (2) während des Leerlaufstopps basierend auf dem Spannungswert ($V_{BattSS}$), dem Stromwert ($I_{EL}$) und einem Leerlaufspannungswert ($V_0$);

Schätzen eines zweiten Spannungswerts ($V_{CR}$) der Energiespeichervorrichtung (2), wenn der Leerlaufstopp gestoppt und der Motor (5) neugestartet wird, basierend auf dem Leerlaufspannungswert ($V_0$), dem Innenwiderstandswert ($R_{ss}$), dem Stromwert ($I_{EL}$) und einem Anlassstromwert ($I_{ST}$); und

Bestimmen, ob ein Neustart des Motors (5) möglich ist oder nicht, basierend auf dem zweiten Spannungswert ($V_{CR}$) und einem Betriebsspannungswert ($V_{RESTmin}$) eines Anlassermotors (3) des Motors (5),

wobei der zweite Spannungswert ($V_{CR}$) mit dem Betriebsspannungswert ($V_{RESTmin}$) verglichen wird, um zu bestimmen, ob ein Neustart möglich ist,

wobei bestimmt wird, dass der Neustart möglich ist, wenn $V_{CR} \geq V_{RESTmin}$ ist, und bestimmt wird, dass der Neustart nicht möglich ist, wenn $V_{CR} < V_{RESTmin}$ ist.

## Revendications

1. Dispositif de détermination de redémarrage, comprenant :

   une unité d'acquisition de valeur de tension (44) configurée pour acquérir une première valeur de tension ($V_{Battss}$) entre des bornes (28, 29) d'un dispositif de stockage d'énergie (2) pendant un arrêt de ralenti pour arrêter le ralenti d'un moteur (5) ;
   une unité d'acquisition de valeur de courant (45) configurée pour acquérir une valeur ($I_{EL}$) d'un courant circulant à travers le dispositif de stockage d'énergie (2) pendant l'arrêt de ralenti ;
   une unité de calcul (49) configurée pour calculer une valeur de résistance interne ($R_{SS}$) du dispositif de stockage d'énergie (2) pendant l'arrêt de ralenti, sur la base de la première valeur de tension ($V_{BattSS}$), de la valeur de courant ($I_{EL}$), et d'une valeur de tension à vide ($V_0$) ;
   une unité d'estimation configurée pour estimer une seconde valeur de tension ($V_{CR}$) du dispositif de stockage d'énergie (2) lors de l'arrêt de l'arrêt de ralenti et lors du redémarrage du moteur (5), sur la base de la valeur de tension à vide ($V_0$), de la valeur de résistance interne ($R_{ss}$), de la valeur de courant ($I_{EL}$), et d'une valeur de courant de lancement ($I_{ST}$) ; et
   une unité de détermination (51) configurée pour déterminer si un redémarrage du moteur (5) est possible ou non, sur la base de la seconde valeur de tension ($V_{CR}$) et d'une valeur de tension de fonctionnement ($V_{RESTmin}$) d'un démarreur (3) du moteur (5),
   dans lequel l'unité de détermination (51) est configurée pour comparer la seconde valeur de tension ($V_{CR}$) à la valeur de tension de fonctionnement ($V_{RESTmin}$) pour déterminer si un redémarrage est possible,
   dans lequel l'unité de détermination (51) est configurée pour déterminer que le redémarrage est possible lorsque $V_{CR} \geq V_{RESTmin}$, et l'unité de détermination (51) est configurée pour déterminer que le redémarrage n'est pas possible lorsque $V_{CR} < V_{RESTmin}$.

2. Dispositif de détermination de redémarrage selon la revendication 1, dans lequel l'unité de calcul (49) est configurée pour calculer la valeur de résistance interne ($R_{ss}$) en divisant une différence entre la valeur de tension à vide ($V_0$) et la première valeur de tension ($V_{BattSS}$) par la valeur de courant ($I_{EL}$) .

3. Dispositif de détermination de redémarrage selon la revendication 1 ou 2, comprenant en outre une unité de demande (52) configurée pour arrêter l'arrêt de ralenti et demander un redémarrage lorsque l'unité de détermination (51) détermine que $V_{CR} < V_{RESTmin}$, dans lequel la valeur de tension de fonctionnement $V_{RESTmin}$ ou la seconde valeur de tension $V_{CR}$ est dotée d'une marge en conformité avec la quantité d'énergie électrique pour le redémarrage.

4. Dispositif de détermination de redémarrage selon l'une quelconque des revendications 1 à 3, comprenant en outre une unité de stockage (53) configurée pour stocker une carte représentant la valeur de tension à vide ($V_0$) pour chaque température et chaque état de charge (EDC) du dispositif de stockage d'énergie (2) pendant l'arrêt de ralenti, dans lequel l'unité de calcul (49) est configurée pour acquérir la valeur de tension à vide ($V_0$) en référence à la carte.

5. Dispositif de détermination de court-circuit interne, comprenant le dispositif de détermination de redémarrage selon la revendication 1, dans lequel l'unité de détermination (51) est en outre configurée pour déterminer la présence ou l'absence d'un court-circuit interne dans le dispositif de stockage d'énergie (2) sur la base de la valeur de

résistance interne ($R_{ss}$).

6. Procédé de détermination de redémarrage, comprenant :

l' acquisition d'une valeur de tension ($V_{BattSS}$) entre des bornes (28, 29) d'un dispositif de stockage d'énergie (2) et d'une valeur ($I_{EL}$) d'un courant circulant à travers le dispositif de stockage d'énergie (2) pendant un arrêt de ralenti pour arrêter le ralenti d'un moteur (5) ;
le calcul d'une valeur de résistance interne ($R_{ss}$) du dispositif de stockage d'énergie (2) pendant l'arrêt de ralenti, sur la base de la valeur de tension ($V_{BattSS}$), de la valeur de courant ($I_{EL}$), et d'une valeur de tension à vide ($V_0$) ;
l'estimation d'une seconde valeur de tension ($V_{CR}$) du dispositif de stockage d'énergie (2) lors de l'arrêt de l'arrêt de ralenti et lors du redémarrage du moteur (5), sur la base de la valeur de tension à vide ($V_0$), de la valeur de résistance interne ($R_{ss}$), de la valeur de courant ($I_{EL}$), et d'une valeur de courant de lancement ($I_{ST}$) ; et
la détermination pour savoir si un redémarrage du moteur (5) est possible ou non, sur la base de la seconde valeur de tension ($V_{CR}$) et d'une valeur de tension de fonctionnement ($V_{RESTmin}$) d'un démarreur (3) du moteur (5), dans lequel la seconde valeur de tension ($V_{CR}$) est comparée à la valeur de tension de fonctionnement ($V_{RESTmin}$) pour déterminer si un redémarrage est possible,
dans lequel il est déterminé que le redémarrage est possible lorsque $V_{CR} \geq V_{RESTmin}$, et il est déterminé que le redémarrage n'est pas possible lorsque $V_{CR} < V_{RESTmin}$.

7. Programme informatique pour amener un ordinateur à exécuter un processus consistant à :

acquérir une valeur de tension ($V_{BattSS}$) entre des bornes (28, 29) d'un dispositif de stockage d'énergie (2) et une valeur ($I_{EL}$) d'un courant circulant à travers le dispositif de stockage d'énergie (2) pendant un arrêt de ralenti pour arrêter le ralenti d'un moteur (5) ;
calculer une valeur de résistance interne ($R_{ss}$) du dispositif de stockage d'énergie (2) pendant l'arrêt de ralenti, sur la base de la valeur de tension ($V_{BattSS}$), de la valeur de courant ($I_{EL}$) et d'une valeur de tension à vide ($V_0$) ;
estimer une seconde valeur de tension ($V_{CR}$) du dispositif de stockage d'énergie (2) lors de l'arrêt de l'arrêt de ralenti et lors du redémarrage du moteur (5), sur la base de la valeur de tension à vide ($V_0$), de la valeur de résistance interne ($R_{ss}$), de la valeur de courant ($I_{EL}$), et d'une valeur de courant de lancement ($I_{ST}$) ; et
déterminer si un redémarrage du moteur (5) est possible ou non, sur la base de la seconde valeur de tension ($V_{CR}$) et d'une valeur de tension de fonctionnement ($V_{RESTmin}$) d'un démarreur (3) du moteur (5),
dans lequel la seconde valeur de tension ($V_{CR}$) est comparée à la valeur de tension de fonctionnement ($V_{RESTmin}$) pour déterminer si un redémarrage est possible,
dans lequel il est déterminé que le redémarrage est possible lorsque $V_{CR} \geq V_{RESTmin}$, et il est déterminé que le redémarrage n'est pas possible lorsque $V_{CR} < V_{RESTmin}$.

Fig. 1

Fig. 2

**4**

**BMU**

**41**

Control unit

**51** Determination unit

**52** Request unit

**46** $V_{RESTmin}$ calculation unit

**42** First temperature acquisition unit

**47** $I_{ST}$ ($T_{ST}$) calculation unit

**43** Second temperature acquisition unit

**50** $V_{CR}$ calculation unit

**48** $V_0$ ($T_{Batt}$, SOC) calculation unit

**44** Voltage value acquisition unit

$R_{SS}$ calculation unit

**49**

**45** Current value acquisition unit

**53** Storage unit

**54** Restart determination program

**55** Map data

**56** Input unit

**57** Interface unit

Fig. 3

Fig. 4

Fig. 5

Fig. 6

Fig. 7

Fig. 8

Fig. 9

Fig. 10

Fig. 11

Start

S1

IG-ON?

NO

YES

S2

During idling stop ?

NO

YES

Acquire $V_{BattSS}$, $I_{EL}$, $T_{Batt}$, $T_{ST}$, and SOC — S3

Acquire $V_0$ ($T_{Batt}$, SOC) — S4

Calculate $I_{ST}$ ($T_{ST}$) — S5

Calculate $R_{SS}$ — S6

Calculate $V_{CR}$ — S7

Acquire $V_{RESTmin}$ — S8

S9

$V_{CR} < V_{RESTmin}$ ?

NO

YES

Request restart — S10

End

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2016114584 A

- US 20070013347 A1